(19) Europäisches Patentamt / European Patent Office / Office européen des brevets

(11) **EP 2 855 056 B1**

(12) **FASCICULE DE BREVET EUROPEEN**

(45) Date de publication et mention de la délivrance du brevet:
**14.09.2016 Bulletin 2016/37**

(21) Numéro de dépôt: **13730013.3**

(22) Date de dépôt: **31.05.2013**

(51) Int Cl.:
**B22F 3/105** *(2006.01)*  **C22C 1/04** *(2006.01)*
**C22C 29/18** *(2006.01)*  **H01L 35/16** *(2006.01)*
**H01L 35/26** *(2006.01)*  **H01L 35/34** *(2006.01)*

(86) Numéro de dépôt international:
**PCT/FR2013/051237**

(87) Numéro de publication internationale:
**WO 2013/182789 (12.12.2013 Gazette 2013/50)**

(54) **PROCÉDÉ DE FABRICATION D'UN MATÉRIAU THERMOÉLECTRIQUE**

VERFAHREN ZUR HERSTELLUNG EINES THERMOELEKTRISCHEN MATERIALS

PROCESS FOR MANUFACTURING A THERMOELECTRIC MATERIAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.06.2012 FR 1255160**

(43) Date de publication de la demande:
**08.04.2015 Bulletin 2015/15**

(73) Titulaire: **Commissariat à l'Énergie Atomique et aux Énergies Alternatives 75015 Paris (FR)**

(72) Inventeurs:
• **SOULIER, Mathieu**
  **F-38130 Echirolles (FR)**
• **MARINOVA-ATANAS, Maya**
  **F-38000 Grenoble (FR)**
• **MINGO BISQUERT, Natalio**
  **F-38360 Sassenage (FR)**
• **NAVONE, Christelle**
  **F-38430 Saint Jean De Moirans (FR)**
• **NERI, Amandine**
  **F-26000 Valence (FR)**

(74) Mandataire: **Cabinet Laurent & Charras Le Contemporain 50 Chemin de la Bruyère 69574 Dardilly Cedex (FR)**

(56) Documents cités:
**WO-A2-2008/140596     US-A- 3 285 017**

• **SCOVILLE N ET AL: "Status of p-type SiGe alloys with nanophase inclusions", AIP CONFERENCE PROCEEDINGS, AMERICAN INSTITUTE OF PHYSICS, NEW YORK, US, no. 316, 1 janvier 1995 (1995-01-01), pages 110-114, XP009115285, ISSN: 0094-243X**
• **JESSER W A ET AL: "Microstructure of thermoelectric SiGe alloys containing fullerite", MATERIALS SCIENCE AND ENGINEERING B, ELSEVIER SEQUOIA, LAUSANNE, CH, vol. 33, no. 2/3, 1 septembre 1995 (1995-09-01), pages 195-203, XP004002372, ISSN: 0921-5107, DOI: 10.1016/0921-5107(94)01183-4**

**Description**

**DOMAINE DE L'INVENTION**

La présente invention concerne un procédé pour augmenter les propriétés thermoélectriques d'une matrice de type SiGe par siliciuration in situ.

Plus précisément, une seconde phase sous la forme de nanoparticules métalliques est introduite au sein de la matrice, puis l'ensemble est soumis à un frittage à une température adaptée, engendrant une modification de la composition et de la microstructure de la matrice.

**ETAT DE LA TECHNIQUE**

L'effet thermoélectrique est basé sur deux principes :

- une différence de potentiel apparaît à la jonction de deux matériaux soumis à une différence de température ;
- une différence de température apparaît à la jonction de deux matériaux de nature différente soumis à un courant électrique.

L'effet thermoélectrique trouve des applications multiples, comme la réfrigération thermoélectrique ou la génération d'électricité.

Cependant, les faibles rendements de conversion par effet thermoélectrique limitent à l'heure actuelle les applications commerciales, notamment sur l'aspect génération d'électricité. A titre d'exemple, des modules thermoélectriques à radio-isotope sont utilisés pour l'alimentation des sondes spatiales. La généralisation des modules thermoélectriques sur le marché est conditionnée par une nécessaire augmentation du rendement de conversion qui dépend des propriétés des matériaux utilisés.

Le rendement d'un système de réfrigération thermoélectrique et celui de l'effet thermoélectrique pour la génération d'électricité dépendent de la température et d'une grandeur adimensionnelle appelée « facteur de mérite ».

Les propriétés d'un matériau thermoélectrique sont quantifiées par le facteur de mérite ZT selon la relation suivante :

$$ZT = \sigma.S^2/\lambda.T$$

dans laquelle :

- $\sigma$ est la conductivité électrique,
- S est le coefficient Seebeck,
- $\lambda$ est la conductivité thermique, et
- T est la température moyenne.

Idéalement, un matériau thermoélectrique présentant un bon rendement possédera donc un coefficient de mérite Z élevé, c'est à dire simultanément un coefficient Seebeck élevé, une bonne conductivité électrique (une faible résistance électrique), et une faible conductivité thermique.

La conductivité thermique représente la quantité de chaleur transférée par unité de surface et par unité de temps sous un gradient de température de 1 degré par mètre. La conductivité thermique est liée d'une part à la conductivité électrique (mouvement des porteurs de charge) et d'autre part à la structure même du matériau (vibrations des atomes). En effet, dans un solide, les vibrations des atomes ne sont pas aléatoires et indépendantes les unes des autres, mais correspondent à des modes propres de vibration, aussi appelés « phonons ». Ces modes propres de vibration correspondent à des ondes qui peuvent se propager dans le matériau, si sa structure est périodique (organisée).

L'une des façons d'augmenter le facteur de mérite ZT est de diminuer la conductivité thermique de réseau en réalisant un matériau thermoélectrique nanostructuré. Cet effet est la conséquence d'une plus grande diffusion des phonons, qui peut être apportée :

- soit par une nanostructuration des grains qui constituent la matrice du matériau (Wang *et al.*, 2008), avec une taille des grains inférieure au libre parcours moyen des phonons et qui en pratique dépend du matériau (< 50 nanomètres pour les métaux et pouvant aller jusqu'au micron pour certains alliages);
- soit par l'ajout d'une seconde phase qui permet de définir des nano-domaines ou inclusions au sein d'une matrice submicronique ou micronique (Mingo *et al.*, 2009).

Plus précisément, le document Wang *et al.* décrit un alliage SiGe dopé-n synthétisé à partir de poudres densifiées par SPS (pour l'acronymeexpression anglo-saxonne « *Spark Plasma Sintering* »), présentant une structure à grains nanométriques (10-20 nanomètres). Cette particularité permet d'atteindre une forte amélioration du facteur de mérite (1,3 à 900°C) imputable à une réduction significative de la conductivité thermique due à l'augmentation de la diffusion des phonons par la densité importante des joints de grains dans le matériau.

Le document Mingo *et al.*, quant à lui, décrit, par des calculs théoriques, comment l'inclusion de nanoparticules d'une phase secondaire dans un alliage SiGe conduit à une amélioration du facteur de mérite. 17 siliciures ont ainsi été évalués comme potentiellement intéressants. A haute température, cette nouvelle classe de matériaux pourrait permettre d'atteindre des valeurs de facteur de mérite proche de 2. Pour des particules de taille comprise entre 2 et 10 nanomètres, l'amélioration des performances est maximale mais une amélioration devrait être visible même avec des particules de taille supérieure, surtout dans le cas d'alliage thermoélectrique.

Comme déjà dit, la conductivité thermique est portée notamment par les phonons. Le phonon est une quasi particule qui résulte du déplacement de un ou plusieurs atomes autour de leur position d'équilibre. La présence de nanostructures au sein du matériau réduit le libre parcours moyen des phonons et donc la conductivité thermique. Ainsi, la diffusion des phonons est perturbée lorsque la taille des grains ou des inclusions est inférieure ou comparable au libre parcours moyen des phonons. Cette taille dite nanométrique est comprise entre 1 et 1000 nanomètres, mais préférablement comprise entre 2 et 20 nanomètres pour perturber la diffusion d'un plus grand nombre de phonons. Le libre parcours moyens d'un phonon est défini comme la distance moyenne que parcourt un phonon sans collision (soit entre deux collisions).

Un matériau thermoélectrique adapté, par exemple avec siliciures, doit répondre aux contraintes suivantes :

1/ Conservation voire augmentation du facteur de puissance par rapport au matériau thermoélectrique par exemple sans siliciures.

Le facteur de puissance correspond au produit de la conductivité électrique ($\sigma$) par le coefficient Seebeck au carré ($S^2$) du matériau initial de type $Si_{1-x}Ge_x$. Sa conservation permet de garantir que la propagation des porteurs de charge dans le matériau n'est pas affectée. L'élévation du facteur de puissance peut néanmoins apparaître dans certains cas :

- soit par une augmentation de la conductivité électrique due à un effet de dopage des siliciures ;
- soit par une augmentation locale de la densité d'états des porteurs de charge jusqu'au niveau de Fermi grâce à la nano structuration.

Ainsi, il faut que le matériau final ($Si_{1-x}Ge_x$ + siliciures $M_aSi_b$) soit dense : Ce matériau doit présenter une densité relative supérieure à 90% afin de garantir un facteur de puissance élevé, comparable au matériau initial. A titre d'exemple, la masse volumique du $Si_{0,8}Ge_{0,2}$ est de 3g/cm$^3$. L'incorporation des siliciures doit se faire en garantissant une bonne cohésion des siliciures avec la matrice. Elle ne doit pas engendrer de dislocations supplémentaires pouvant perturber la conductivité électrique.

Par ailleurs, l'inclusion métallique et plus particulièrement les siliciures formés doivent rester nanométriques, c'est-à-dire présenter au moins une dimension inférieure au micron. Introduire un nouvel élément dans un matériau thermoélectrique donne lieu à un matériau composite présentant des caractéristiques électriques et thermiques nouvelles, intermédiaires entre celles de l'élément ajouté et celles du matériau thermoélectrique. Ces modifications de propriétés ne permettent pas d'augmenter le facteur de mérite puisque l'augmentation de la conductivité électrique se fera toujours au détriment de la conductivité thermique (et inversement). Ces modifications sont d'autant plus marquées :

- que la différence de propriétés électriques et thermiques entre l'inclusion et le matériau thermoélectrique est importante ;
- que la proportion volumique des éléments ajoutés est grande.

Dans le cadre de la présente invention, l'effet recherché n'est pas celui de l'effet composite puisque l'on cherche à augmenter le facteur de mérite. Pour cela, on jouera sur l'effet « nanométrique » et plus que sur l'effet composite ; Ainsi, la proportion volumique d'élément ajouté restera faible, avantageusement de 0,2 à 20%.

En outre, l'inclusion ne doit pas jouer le rôle de dopant mais un rôle limité au sein de la matrice à base de SiGe. En effet, une modification du dopage (ou nombre de porteurs de charges) a pour effet de modifier à la fois le coefficient Seebeck et la conductivité électrique du matériau. On considère que l'ajout d'inclusions ne doit pas faire sortir le taux de dopage global du matériau de la plage $1.10^{19}$ à $1.10^{20}$ voire $1.10^{21}$ porteurs par cm$^3$.

2/ Diminution de la conductivité thermique :

Il faut garantir la taille nanométrique des siliciures pour un abaissement de la conductivité thermique. La conductivité thermique est abaissée dès 1000 nanomètres mais a un effet optimal entre 2 et 5 nanomètres suivant la nature de l'inclusion. Comme déjà dit, on ne cherche pas ici à bénéficier d'un effet composite. En effet, l'ajout d'une seconde phase non nanométrique peut également diminuer la conductivité thermique mais elle impactera également sur le facteur de puissance.

Là encore et de préférence, l'inclusion ne doit pas modifier la conductivité thermique.

L'abaissement de la conductivité thermique peut se faire par une modification de la microstructure et de la composition du matériau hôte. La formation contrôlée de porosité, la présence de mâcles ainsi que celle d'interfaces de joints de grains cohérents de basse énergie dans le matériau influencent également le transport thermique dans le matériau. La présence d'un dépôt d'oxydes à la surface des nanosiliciures peut également participer à une réduction de la conductivité thermique.

3/ Problème de disponibilité sur le marché de siliciures nanométriques :

Une difficulté supplémentaire est qu'il n'existe pas aujourd'hui, sur le marché, de siliciures métalliques de taille nanométrique suffisante, avantageusement inférieure à 500 nanomètres.

Il est cependant envisageable de former le siliciure durant la phase de frittage (Scoville *et al.*, 1995). Scoville *et al.* ont ainsi tenté d'augmenter le facteur de puissance par ce biais. Ce document décrit un matériau SiGe associé à des siliciures métalliques de type $M_5Si_3$ et $M_3Si$ (avec M=Ti, V, Cr) qui réagissent au cours du frittage pour donner $MSi_2$. Ce document mentionne une croissance inévitable des inclusions durant le frittage, empêchant toute amélioration du facteur de mérite voire une réduction de ce facteur.

Par ailleurs, dans le document WO 2008/140596, il est mentionné un matériau SiGe avec des nano-inclusions de $MoSi_2$ formé par siliciuration, permettant une augmentation du facteur de mérite. Dans ce procédé en plusieurs étapes, il y a ajout de molybdène à du SiGe, puis fusion du matériau, suivie d'un refroidissement pour obtenir des lingots. Ces lingots sont ensuite broyés et compactés si nécessaire. Selon cette approche où la siliciuration se fait en voie liquide, les siliciures sont formés pendant l'étape de refroidissement, qui suit une étape indispensable de fusion. A noter que ce document est totalement silencieux sur une quelconque modification microstructurale de la matrice SiGe lors de cette siliciuration. Or, la réalisation des siliciures modifie nécessairement la composition et la microstructure de l'alliage. Il ressort donc que dans ce document, cette modification n'est pas maîtrisée, ce qui peut rendre l'apport des siliciures inefficace ou non optimale. Ainsi, la siliciuration peut créer des contraintes au sein du matériau et créer des fissurations.

Il existe donc un besoin évident de développer des solutions techniques permettant d'obtenir des matériaux thermoélectriques présentent les propriétés mentionnées ci-dessus.

**EXPOSE DE L'INVENTION**

La présente invention concerne une méthode de fabrication d'un matériau thermoélectrique de type SiGe, dans lequel la nanostructuration est apportée par une seconde phase. Les conditions du procédé de fabrication, permettant d'aboutir à une augmentation effective des performances thermoélectriques (Z) du matériau, suivent une plage de sélection étroite, définie dans le cadre de la présente invention.

En d'autres termes, la présente invention propose un procédé permettant d'augmenter les performances thermoélectrique d'un alliage de type SiGe par une modification de sa composition et de sa microstructure, due à l'ajout d'une seconde phase, en l'occurrence des nanoinclusions de siliciures métalliques (MSi) formées in situ.

Ainsi et selon un premier aspect, la présente invention vise un procédé de fabrication d'un matériau thermoélectrique qui comprend les étapes suivantes :

- préparer une poudre à partir d'un alliage thermoélectrique au moins binaire ($A_xB_{1-x}$) destiné à servir de matrice ;
- mélanger la poudre ainsi obtenue à des nanoparticules de métal pur (M) destinées à former des inclusions dans la matrice ;
- soumettre le mélange à une étape de frittage à une température adaptée, comprise entre la température permettant d'atteindre 90 % de la densification maximum et la température de fusion du métal M et de l'alliage ($A_xB_{1-x}$), au cours de laquelle des inclusions nanométriques de composition $M_aA_b$ et/ou $M_aB_b$ sont formées dans la matrice.

Comme mentionné, le matériau initial, destiné à servir de matrice dans le matériau final obtenu à l'issue du procédé selon l'invention, est un matériau qui présente lui-même des propriétés thermoélectriques. En outre, il s'agit avantageusement d'un matériau au moins binaire de formule $A_xB_{1-x}$ avec $0<x<1$.

Il peut aussi s'agir d'un matériau ternaire (ABC), voire quaternaire (ABCD), pour lequel la formation d'une seconde phase nanométrique avec un métal M, permet d'apporter la modification microstructurale (sous forme d'inclusions) apte à réduire significativement la conductivité thermique du matériau, sans réduction du facteur de puissance, en d'autres termes à améliorer les propriétés thermoélectrique reflétées par la grandeur Z.

Comme déjà dit, il s'agit avantageusement d'un alliage. En effet, un alliage a un réseau d'atomes désordonné, comparativement à un matériau constitué d'un seul type d'atomes. Ce désordre permet ainsi de réduire le libre parcours moyen d'une partie des phonons, à savoir les phonons de haute fréquence. La conséquence est une première réduction de la conductivité thermique grâce à l'utilisation d'un alliage comme matrice.

Concernant les phonons de basse fréquence, qui eux gardent un libre parcours moyen élevé dans un alliage et sont responsables du transport de la chaleur dans un alliage, c'est l'ajout selon l'invention des nano-inclusions qui les perturbe et réduit encore la conductivité thermique de l'alliage.

Ainsi, les nanoinclusions (ou siliciures dans le cas d'une matrice contenant Si) permettent un abaissement de la conductivité thermique d'une matrice non alliée mais l'abaissement est encore plus marqué si les effets d'un alliage et des nanoinclusions sont conjugués.

Avantageusement, un alliage mis en oeuvre dans le cadre de la présente invention comprend du silicium (A ou B = Si), les nanoinclusions formées à l'issue du procédé selon l'invention étant alors des siliciures. Dans le cas particulier d'une matrice SiGe, l'inclusion obtenue à l'issue du procédé est donc un siliciure de formule $M_aSi_b$, en particulier $MSi_2$. Dans la généralisation à tout alliage au moins binaire ($A_xB_{1-x}$), l'inclusion, après sa réaction à l'état solide avec la matrice lors du frittage, forme alors un alliage de composition $M_aA_b$ ou $M_aB_b$.

Typiquement et comme déjà dit, l'alliage mis en oeuvre peut être du SiGe à différentes stoechiométries et donc de formule générale $Si_{1-x}Ge_x$ avec 0<x<1, avantageusement avec $0,01 \leq x \leq 0,5$, encore plus avantageusement $0,01 < x \leq 0,2$. Il s'agit par exemple de $Si_{0,8}Ge_{0,2}$ avec x = 0,2 ou de $Si_{0,92}Ge_{0,08}$ avec x = 0,08.

Dans le cas d'une matrice SiGe, la proportion de Germanium définit en grande partie la conductivité thermique de celle-ci. En effet, plus sa teneur est grande, plus la conductivité thermique de l'alliage sera avantageusement abaissée. Ainsi, elle varie de 140-150 W/m/K lorsque x = 0 à 4-6 W/m/K lorsque x = 0,2. En pratique, x désignant la stcechiométrie en Ge est avantageusement comprise entre 0,01 et 0,5.

Selon un mode de réalisation particulier, ce matériau est dopé avec des agents dopants tels que le phosphore (P) ou le bore (B).

Dans le cas du SiGe, il s'agit avantageusement du phosphore quand l'alliage est dopé n et du bore lorsque l'alliage est dopé p. Les formules correspondantes sont ($Si_{1-x-y}Ge_xP_y$) et $Si_{1-x-y}Ge_xB_y$, respectivement, avantageusement avec $0,001 \leq y \leq 0,1$.

A titre d'exemple et selon un mode de réalisation privilégié, une matrice dopée p présente la formule $Si_{0,795}Ge_{0,2}B_{0,05}$ et une matrice dopée n $Si_{0,795}Ge_{0,2}P_{0,005}$.

Avantageusement, l'agent dopant, tel que le bore ou le phosphore, représente entre $10^{19}$ et $10^{20}$, voire entre $10^{19}$ et $10^{21}$ particules par $cm^3$ du matériau au moins binaire. La modulation du taux de dopage se fait en faisant varier la quantité de l'agent dopant, du bore par exemple dans une matrice dopée p et du phosphore par exemple dans une matrice dopée n.

Un alliage binaire alternatif pouvant servir de matrice est le $Mg_2Sn$.

Dans l'étape suivante, cette poudre est mélangée à des particules métalliques.

De manière caractéristique selon l'invention, les particules mélangées à la matrice sont des particules de métal pur M, qui présentent en outre une taille nanométrique.

On entend par « nanoparticules » le fait que les particules présentent, dans au moins une de leurs dimensions, préférentiellement dans toutes leurs dimensions, une taille inférieure à 1000 nanomètres, avantageusement inférieure à 500 nanomètres, encore plus avantageusement comprise entre 2 et 20 nanomètres. A noter que ces mêmes propriétés de taille sont recherchées pour les siliciures ou alliages $M_aA_b$ ou $M_aB_b$ obtenus à l'issue du frittage. En pratique, les particules initiales de métal pur M doivent être de 1,5 à 5 fois plus petites que la taille souhaitée pour les inclusions $M_aA_b$ ou $M_aB_b$, qui elles-mêmes devront respecter les dimensions décrites précédemment, à savoir : une taille inférieure à 1000 nanomètres, avantageusement inférieure à 500 nanomètres, encore plus avantageusement comprise entre 2 et 20 nanomètres.

Différents métaux M peuvent être envisagés, dont la nature dépend de la matrice dans laquelle ils vont être introduits sous forme de particules nanométriques. En effet, il existe un certain nombre de contraintes sur les particules métalliques, notamment pour observer une augmentation du facteur de mérite.

L'une des contraintes concerne le point de fusion (ou température de fusion) dudit métal, qui doit être supérieur à la température de frittage appliquée.

En effet, pendant l'étape de frittage, le matériau AB, avantageusement SiGe, et ses inclusions métalliques M ne doivent pas entrer en fusion. Le siliciure (MA, en particulier MSi) se forme pendant le frittage, à l'état solide. Il doit en outre être stable sans subir de décomposition ou de fusion à la température de frittage de la matrice, avantageusement SiGe. Ceci permet d'éviter une ségrégation, une décomposition des siliciures lors du refroidissement, avec comme conséquence un matériau composite non homogène. Cette condition constitue une différence significative avec le document WO 2008/140596 qui propose une formation des siliciures lors du refroidissement, après un passage en voie liquide, en pratique après fusion.

Dans le cadre du procédé selon l'invention, la matrice comme les nanoparticules de métal sont à l'état solide et la formation des nanoinclusions se fait par voie solide.

En d'autres termes, le siliciure ($M_aSi_b$), ou plus généralement l'alliage $M_aA_b$ ou $M_aB_b$ doit être formé à partir d'un métal (M) de transition réfractaire, présentant une température de fusion supérieure à la température de frittage. La température de frittage varie selon la composition de la matrice elle-même et sera définie ci-dessous.

Tous les éléments métalliques qui répondent à ces critères pourront être utilisés comme par exemple le vanadium (V), le tungstène (W), le molybdène (Mo), le zirconium (Zr) et le titane (Ti), qui formeront notamment des siliciures réfractaires hautement conducteurs $VSi_2$, $WSi_2$, $MoSi_2$, $ZrSi_2$ et $TiSi_2$.

Le chrome (Cr) et le fer (Fe) peuvent être utilisés, notamment pour former des siliciures réfractaires semi-conducteurs $CrSi_2$ et $FeSi_2$, respectivement. Le tantale (Ta), le cobalt (Co) et l'osmium (Os) sont également possibles.

Les métaux réfractaires tels que Mo, Ta et W apparaissent particulièrement prometteurs. L'ensemble de ces métaux est avantageusement utilisé dans le cas d'une matrice de type SiGe.

De façon générale, la matrice pourra embarquer différents types de siliciures à la fois, comme par exemple des inclusions de $CrSi_2$ et de $MoSi_2$. Ces différents siliciures pourront avoir des tailles différentes (tout en restant dans la gamme décrite plus haut) pour mieux perturber le transport des phonons et donc faire baisser encore plus avantageusement la conductivité thermique. En pratique, il est donc possible d'utiliser un mélange de poudres métalliques, chaque poudre étant constituée d'un métal pur mais différent.

Pour un autre exemple, à savoir une matrice $Mg_2Sn$, il s'agit avantageusement de nanoparticules métalliques de Te susceptibles de former les alliages MgTe ou SnTe, respectivement.

Un autre critère est la fraction volumique des inclusions dans la matrice. La fraction volumique des inclusions métalliques, qui formeront un siliciure ou plus généralement un alliage dans la matrice AB, est avantageusement comprise entre 0,2 et 20 %. Au-delà, les inclusions peuvent coalescer entre elles et deviennent trop grandes pour permettre une diffusion des phonons.

En pratique et de manière avantageuse, les nanoparticules de métal pur (M) sont donc introduites à hauteur de 0,2 à 20 % en fraction volumique du mélange.

Dans la mesure où le procédé selon l'invention est basé sur une étape de frittage, les différents constituants du matériau thermoélectrique sont donc apportés sous forme de poudres.

La première étape de ce procédé consiste à préparer, si nécessaire, une poudre d'alliage thermoélectrique au moins binaire $(A_xB_{1-x})$, destiné à servir de matrice au matériau thermoélectrique final.

Ainsi, les différents constituants, à savoir les précurseurs de A pur et B pur, par exemple silicium pur (Si) et germanium pur (Ge), ainsi que le dopant, notamment phosphore (P) pour un matériau dopé n, ou bore (B) pour un matériau dopé p, sont utilisés sous forme de poudres, paillettes ou coupeaux, en quantités stoechiométriques.

Cette poudre d'alliage, qui constituera la matrice du matériau, peut être produite par mécanosynthèse, voie chimique, fusion ou encore atomisation.

Dans le cas particulier de la mécanosynthèse, les éléments de broyage utilisés, à savoir le bol de broyage et les billes, sont par exemple en acier inoxydable, en zircone ou encore en carbure de tungstène, et ce pour limiter l'apport d'impuretés au cours du broyage.

Selon un mode de réalisation privilégié, les paramètres de mécanosynthèse sont définis comme suit :

- un ratio masse de billes du broyeur / masse de poudres (Si+Ge+B ou P) compris entre 10 :1 et 50 :1 ;
- une vitesse de rotation du bol comprise entre 300 et 500 tours/minute ;
- un temps de broyage compris entre 4 heures et 20 heures.

Dans une seconde étape, cette poudre de l'alliage d'au moins A et B (AB), par exemple SiGe, éventuellement dopé, est mélangée avec les nanoparticules de métal pur M, judicieusement choisi, dans les proportions indiquées ci-dessus. Selon un mode de réalisation avantageux, les nanoparticules sont préalablement désagglomérées, par exemple par l'utilisation d'un broyeur planétaire ou d'ultrasons.

Le mélange des poudres doit permettre l'homogénéisation complète des deux phases solides, matrice d'une part et particules métalliques d'autre part. Cette étape définit la répartition des inclusions dans le matériau massif densifié. A noter que la bonne dispersion des siliciures ou alliages dans la matrice conditionne, au même degré que leur taille, la diffusion efficace des phonons dans le composite.

Typiquement, le mélange de poudres peut se faire au moyen d'un broyeur à attrition ou un disperseur fonctionnant avec des pales rotatives, ou par mise en mouvement de billes dans un récipient en rotation.

Typiquement, dans un broyeur à attrition, la vitesse de rotation est comprise entre 80 et 300 tours/minute pour un ratio masse de billes/masse de poudres compris entre 10 :1 et 50 :1, et une durée de 10 minutes à 10 heures.

Pour une plus grande efficacité du mélange, cette dispersion des poudres peut s'effectuer en milieu liquide, par exemple en présence d'un solvant organique inerte chimiquement vis-à-vis de la matrice. Dans le cas du SiGe, l'éthanol peut être employé. Des agents dispersants peuvent également être ajoutés pour améliorer la dispersion des particules et éviter leur agglomération.

Selon un mode de réalisation particulier, le mélange de la poudre d'alliage avec les nanoparticules métalliques peut être réalisé pendant une phase d'atomisation de la poudre.

L'étape suivante du procédé selon l'invention consiste à fritter ce mélange. La formation des nanoinclusions se fait in situ, au cours du frittage, contrairement à l'art antérieur.

Ainsi, le procédé selon l'invention se distingue, notamment des enseignements du document WO 2008/140596 par le fait qu'il ne fait pas intervenir d'étape de fusion du matériau et que par conséquent, la formation des siliciures ne se fait pas au cours du refroidissement qui s'en suit. Au contraire et selon l'invention, la siliciuration ou la formation de l'alliage des nanoparticules ou nanoinclusions se produit lors de la compaction, par frittage du mélange particules métalliques/matrice, par exemple Mo/SiGe.

En pratique, le frittage du mélange de poudres est avantageusement effectué par SPS (selon l'acronyme anglo-saxon « *Spark Plasma Sintering* »), pressage uniaxial à chaud (ou PUC), P2C (selon l'acronyme anglo-saxon « *Plasma Pressure Compaction* »), frittage micro-onde ou frittage isostatique.

Le frittage est avantageusement réalisé sous vide, à une pression inférieure ou égale à $10^{-2}$ mbar, ou sous atmosphère inerte, par exemple en présence d'hélium ou d'argon, pour éviter une réaction d'oxydation avec le matériau thermoélectrique.

Pour les méthodes de frittage sous contrainte, de type SPS (selon l'acronyme anglo-saxon « *Spark Plasma Sintering* »), pressage uniaxial à chaud (ou PUC), P2C (selon l'acronyme anglo-saxon « *Plasma Pressure Compaction* ») ou frittage isostatique, la pression appliquée peut varier entre 15 MPa et 300 MPa.

Le frittage doit permettre la densification de la matrice comprenant les inclusions, à hauteur de 85 à 100%, voire 90 à 100% de la densité théorique. La densité théorique correspond à la densité maximale que peut avoir un matériau, lorsqu'il n'a plus aucune porosité. La densité théorique est ramenée à 100%.

De manière cruciale, cette étape de frittage doit également aboutir à la réaction de siliciuration des particules métalliques, ou plus généralement à la formation concomitante, dans la matrice, d'inclusions nanométriques de composition $M_aA_b$ et/ou $M_aB_b$.

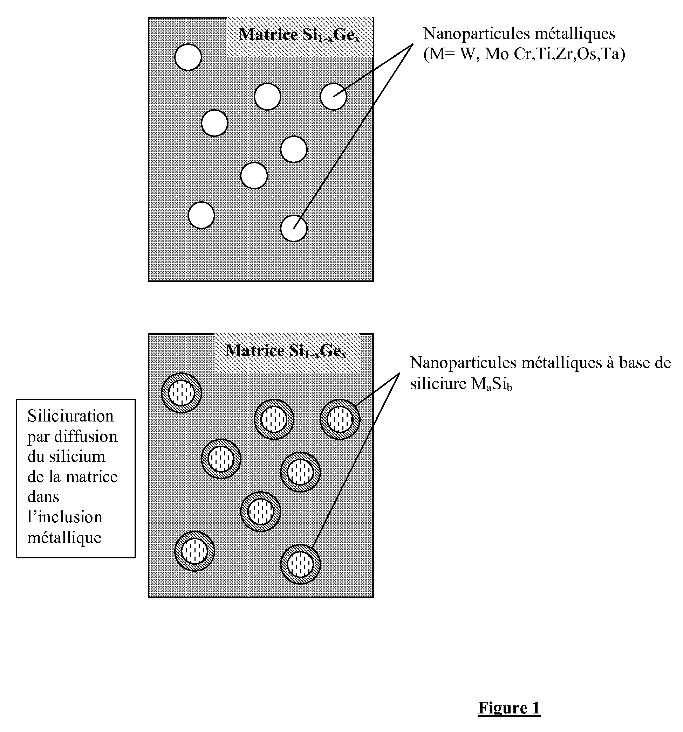

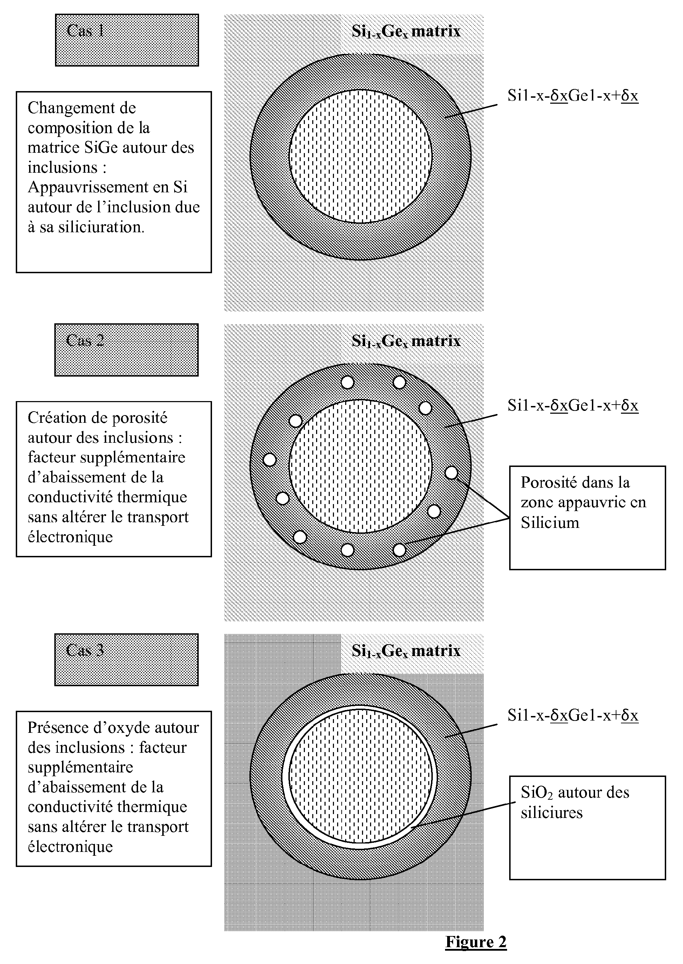

Dans le cadre de l'invention, on entend par « inclusions nanométriques », les structures obtenues à partir des nanoparticules de métal pur (M) à l'issue de l'étape de frittage. En pratique et de manière schématique (figures 1 et 2), il s'agit de ces nanoparticules dans lesquelles l'un des composants de la matrice A ou B diffuse pour réagir au métal pur (M). Des modifications de la matrice peuvent en résulter :

- appauvrissement en A ou B de la matrice autour de ces inclusions ;
- création de porosités dans cette zone appauvrie de la matrice ;
- présence d'oxydes de formule $AO_2$ ou $BO_2$ autour des inclusions.

Un paramètre important de cette étape de frittage est la température à laquelle il est réalisé. La plage de température de frittage est définie en tenant compte des deux critères suivants :

- la limite inférieure de température de frittage correspond au début de la fusion partielle de la matrice, par exemple SiGe, initiant la réaction de siliciuration. Elle correspond également à la température nécessaire pour densifier correctement ($d_{relative}$ minimale de 90%) ;
- la limite supérieure est celle qui correspond à la zone de fusion du matériau ou du siliciure. Elle doit également correspondre à une conservation suffisante de la taille des siliciures.

En pratique, la température de frittage est déterminée sur une courbe de densification du mélange de l'alliage initial (ou plus généralement du matériau au moins binaire ($A_xB_{1-x}$) et des nanoparticules métalliques, et correspond avantageusement à une température supérieure à la température qui permet d'atteindre le sommet du pic de densification, mais inférieure à la température de fusion de cet alliage ou matériau. La température adaptée se situe donc dans une plage limitée déterminée de manière très précise.

Une courbe de densification correspond au suivi de la vitesse de déplacement du piston lors du frittage du matériau à étudier (en prenant soin de soustraire les effets lié à la dilatation du piston). Lors de l'établissement de cette courbe de densification, aucun palier de température ne doit être appliqué : le matériau est soumis à une simple montée de température allant jusqu'à la fusion du matériau étudié. On obtient donc un ou plusieurs « pics de vitesse de densification » qui correspondent aux températures où la densification du mélange est élevée. Après densification du mélange, la vitesse de déplacement du piston diminue fortement voir peut devenir nulle. Elle ré-augmente ensuite de façon drastique : cette augmentation correspond à la fusion du mélange.

La présente invention définit la zone de frittage à utiliser pour le mélange du matériau initial comprenant les nanoparticules métalliques. Cette zone de température est comprise entre la température permettant d'atteindre le pic de densification maximum (= température permettant de densifier le matériau à une vitesse maximale) et la température de fusion du matériau, température où la vitesse de déplacement du piston ré-augmente de façon drastique.

A noter en outre que cette température doit être inférieure à la température de fusion du métal (M) des nanoparticules.

Elle est généralement comprise entre 60% et 99,99 % de la température de fusion de l'alliage, visible sur le diagramme de phase du matériau étudié. A titre d'exemple, l'alliage $Si_{0.8}Ge_{0.2}$ fond vers 1300 °C et peut être fritté dans la gamme 900-1299 °C. En pratique, la température de frittage se détermine sur les courbes de densification du mélange (matrice + nanoparticules). En effet, la présence de nanoparticules peut décaler les températures de frittage et de fusion du matériau vers de plus hautes ou plus basses températures. C'est donc avantageusement sur le mélange que doivent être réalisés les courbes de suivi de densification. Ces courbes représentent la vitesse de densification en fonction de la température de frittage. L'efficacité du frittage est maximale entre le sommet du pic de densification et la température de fusion.

Dans le cadre de la présente demande, il a été montré que pour une matrice $Si_{0.8}Ge_{0.2}$, éventuellement dopée, et des nanoparticules de Mo, le frittage est avantageusement réalisé à une température comprise entre 1050 et 1250 °C, encore plus avantageusement comprise entre 1150 et 1250 °C.

Selon un mode de réalisation particulier, pour une matrice $Si_{0.92}Ge_{0.08}$ et des nanoparticules de Mo, l'étape de frittage se déroule avantageusement à une température comprise :

- entre 1280 et 1315°C pour la matrice dopée au phosphore ; et
- entre 1280°C et 1320 °C pour la matrice dopée au bore.

En pratique, les températures de frittage relevées durant le frittage sont prises à proximité du matériau : soit par un pyromètre soit par un thermocouple (TC) placé dans le conteneur de frittage. Il est donc délicat de transposer une valeur de température d'un équipement à un autre ou même d'un conteneur à un autre ou d'une poudre à une autre. La zone de température de frittage est avantageusement déterminée à partir du profil de densification du mélange relevé, sur un équipement donné, avec un moyen de contrôle donné (TC ou pyromètre), un conteneur et un mélange (matériau thermoélectrique + nanoparticules) donnés.

En d'autres termes, l'objet de l'invention consiste à produire un matériau massif de type SiGe, combiné à des inclusions nanométriques de siliciures métalliques, avec une modification de la composition et de la microstructure permettant un gain d'au moins 10% voire 30% voire même 100% sur le facteur de mérite par rapport à la matrice initiale, c'est-à-dire du SiGe sub-micronique.

Le procédé selon l'invention doit également donner lieu à une microstructure originale : modification de la composition de la matrice sur la zone entourant les nanoinclusions, présence de défauts liés au frittage du matériau (mâcles, joints spécifiques), apparition de pores lors de la siliciuration et/ou encore présence d'oxydes sur les pourtours des nanoinclusions.

La microstructure du matériau final ne comprend pas nécessairement toutes ces caractéristiques. Néanmoins ces éléments sont tous favorables à l'augmentation du facteur de mérite et donc à l'efficacité du matériau thermoélectrique. Le matériau obtenu à l'issue du procédé selon l'invention doit présenter au moins l'une de ces caractéristiques, avantageusement toutes.

En d'autres termes, il est nécessaire d'obtenir un matériau thermoélectrique de type SiGe dense, présentant des nanoinclusions ne dégradant pas le facteur de puissance ($\sigma.S^2$) du matériau. Pour cela il faut que les températures de frittage du matériau « hôte » (SiGe) et de siliciuration (avec conservation de la taille nanométrique des inclusions) soient compatibles. Par ailleurs, la siliciuration doit engendrer une modification microstructurale du matériau favorisant l'abaissement de la conductivité thermique.

En effet, tant que le siliciure ne se forme pas, la présence de particules métalliques dans le matériau agit comme dopants : leur présence affecte directement le facteur de puissance. A partir d'une certaine valeur de température de frittage, le siliciure se forme et le facteur de puissance du matériau est similaire à celui de la matrice initiale. L'observation de la conductivité thermique donne alors une information directe sur la microstructure du matériau et la conservation de leur taille nanométrique. Ainsi si l'on dépasse une certaine valeur de température de frittage, les grains de siliciures croissent et atteignent une taille trop importante pour permettre la réduction attendue. L'observation microstructurale par TEM permet alors de valider la structure originale du matériau ainsi formé.

En pratique, le paramétrage des conditions de frittage peut se faire en alliant mesures thermoélectriques (densité, coefficient Seebeck, conductivité électrique et conductivité thermique) et analyses microstructurales.

Dans le document WO 2008/140596, les modifications de composition et de structure de la matrice, induites par la siliciuration, ne sont pas contrôlées et peuvent aboutir à des porosités, agglomérations des siliciures, croissance de grains et/ou diminution du dopage du matériau. Au contraire, les modifications apportées à la matrice dans la présente invention ont été démontrées comme étant favorables à l'augmentation des propriétés thermoélectriques (ZT).

Selon un autre aspect, la présente invention permet d'obtenir un matériau thermoélectrique présentant au moins l'une des caractéristiques suivantes, avantageusement l'ensemble de ces caractéristiques :

- une densité supérieure ou égale à 90% de la densité théorique de la matrice comprenant les inclusions ;
- une augmentation du facteur de mérite supérieure ou égale à 10%, voire supérieure ou égale à 30% voire à 100% par rapport à la matrice sans inclusions ;
- la présence de mâcles dans la matrice ;
- la présence de porosités autour des nanoinclusions ;
- la présence de dépôts d'oxydes autour des nanoinclusions ;
- la présence de joints spécifiques dans la matrice.

De manière avantageuse, le matériau thermoélectrique obtenu selon le procédé de l'invention présente au moins les deux premières caractéristiques mentionnées ci-dessus, à savoir :

- une densité supérieure ou égale à 90% de la densité théorique de la matrice comprenant les inclusions ; et
- une augmentation du facteur de mérite supérieure ou égale à 10%, voire supérieure ou égale à 100%, par rapport à la matrice sans inclusions.

Le procédé selon l'invention permet donc :

- d'obtenir des inclusions de siliciures métalliques qui restent suffisamment petites, à savoir inférieures au micromètre voire de quelques nanomètres, si les particules métalliques initiales présentent cette dimension. Ainsi, il est possible d'obtenir à la fois un abaissement de la conductivité thermique et une augmentation du facteur de mérite (jusqu'à un facteur 2) de la matrice contenant ces inclusions, par exemple un alliage SiGe ;
- de modifier la microstructure du matériau de la matrice, grâce à l'apparition contrôlée de défauts (mâcles, pores, oxydes et/ou joints de grains spécifiques).

## BREVE DESCRIPTION DES FIGURES

La manière dont l'invention peut être réalisée et les avantages qui en découlent ressortiront mieux de l'exemple de réalisation qui suit, donné à titre indicatif et non limitatif, à l'appui des figures annexées parmi lesquelles :

La figure 1 est une représentation schématique de la siliciuration *in situ* du matériau thermoélectrique.
La figure 2 est une représentation schématique de la modification de composition et l'apparition de porosités dans le matériau thermoélectrique.
La figure 3 correspond au suivi de la densification au cours de l'étape de frittage.
La figure 4 représente un diagramme binaire du matériau thermoélectrique étudié.
La figure 5 compare la conductivité électrique (A) et le coefficient Seebeck (B) d'un matériau avec inclusions et sans inclusions.
La figure 6 compare la conductivité thermique d'un matériau avec inclusions et sans inclusions.
La figure 7 représente l'évolution du ZT par nanosiliciuration et modification structurale pour un matériau de type n.
La figure 8 est une vue en microscopie électronique en transmission (TEM) montrant des nanoinclusions de $MoSi_2$ dans SiGe.
La figure 9 révèle la modification de la composition de la matrice autour des inclusions (A et C en TEM ; B par microanalyse EDX), avec la présence de porosités autour des inclusions $MoSi_2$.
La figure 10 est une vue en microscopie électronique en transmission (TEM) révélant la présence de mâcles.
La figure 11 est une vue en microscopie électronique en transmission (TEM) révélant la présence de joints spécifiques.
La figure 12 montre la présence d'un dépôt d'oxydes sur le contour des nanoparticules (A : vue en TEM ; B : microanalyse EDX).
La figure 13 représente l'évolution du ZT par nanosiliciuration et modification structurale pour le cas de $Si_{0.913}Ge_{0.08}B_{0.007}$ avec ajout de 1,3 % volumique de Mo (type p).
La figure 14 représente l'évolution du ZT par nanosiliciuration et modification structurale pour le cas de $Si_{0.913}Ge_{0.08}P_{0.007}$ avec ajout de 1,3 % volumique de Mo (type n).

## MODES DE REALISATION DE L'INVENTION

La présente invention va être illustrée plus avant dans le cas de nanoparticules de molybdène (Mo) représentant 1,3% en poids (0,9% en volume) dans une matrice de $Si_{0,8}Ge_{0,2}$ ($Si_{1-x}Ge_x$ avec x = 0,2).

A l'issue du procédé selon l'invention et tel que schématisé aux figures 1 et 2, on obtient des nanoparticules métalliques à base de siliciure de formule $MoSi_2$.

### 1/ Préparation de la poudre de l'alliage :

Les poudres d'alliages $Si_{1-x-y}Ge_xP_y$ sont préparées par mécanosynthèse. Les poudres de Silicium pur (99.99%), de Germanium pur (99.99%) et de Phosphore (99.99%) sont pesées suivant la stœchiométrie visée (x=0.795; y=0.005) puis placées dans un bol de broyage de 500mL en zircone. Des billes de 10mm de diamètre, également en zircone, sont pesées de sorte que la masse totale de billes placées dans le bol soit égale à 15 fois la masse de poudre (Si, Ge, ou P). On parle de ratio bille/poudre (RBP ou BPR en anglais) de 15 :1.

Les poudres sont broyées dans un broyeur planétaire pendant 12 heures à la vitesse de rotation fixée à 360rpm. A la fin de ce cycle, on obtient les poudres d'alliage SiGe dopées.

### 2/ Ajout des particules de métal:

On ajoute ensuite dans le bol les poudres nanométriques de Molybdène pur (99.99%) à hauteur de 1,3% massique par rapport à la quantité de SiGe présente dans le bol.

On effectue alors, via le broyeur, une étape de mélange de poudres de Molybdène et de SiGe. Dans cet exemple, le mélange se déroule pendant 3h à 220rpm.

### 3/ Frittage du mélange :

Le frittage est réalisé par SPS.

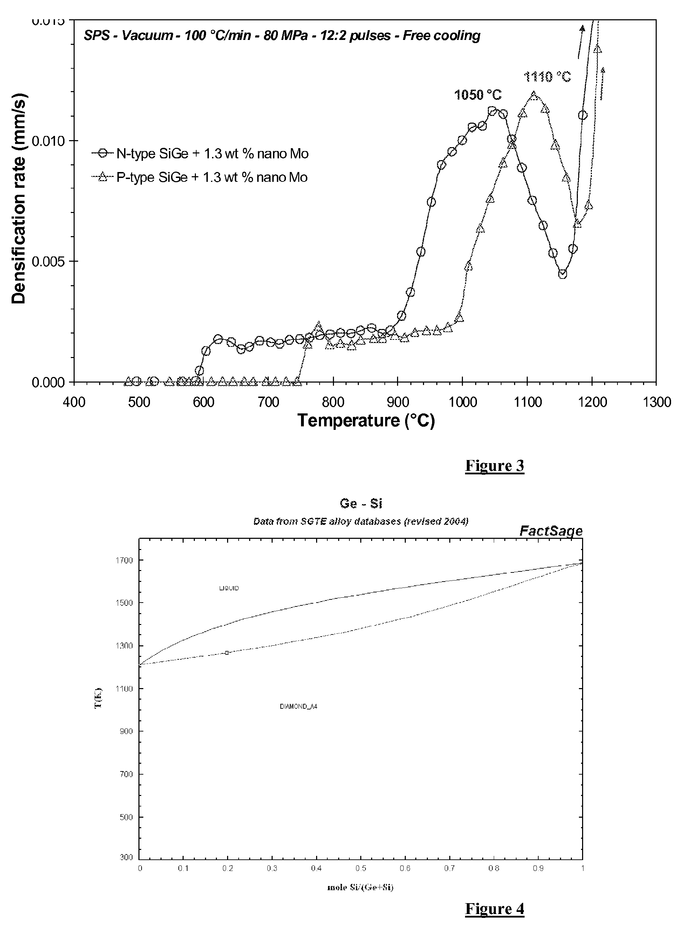

Une première détermination de la zone de température idéale est réalisée en suivant le profil de densification du matériau lors de l'étape de frittage. La figure 3 donne ainsi une première gamme de température pour SiGe de type n : $T_{inf}$ = 1050 °C.

La limite supérieure est, quant à elle, déterminée sur le profil de densification par la remontée drastique de la vitesse de déplacement du piston : $T_{sup}$ = 1165°C.

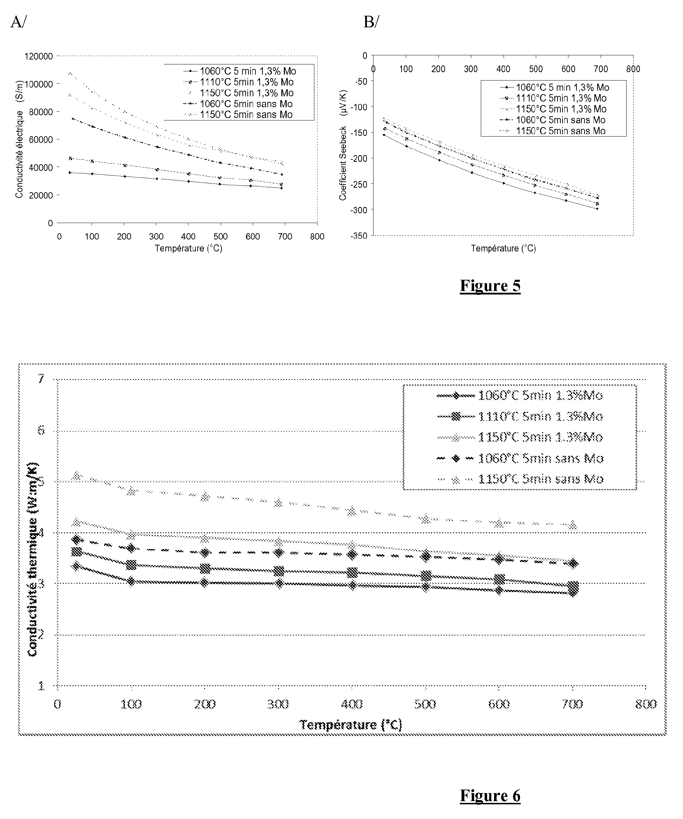

L'affinement de la gamme de température se fait par des mesures de conductivité électrique (figure 5A) et de coefficient Seebeck (figure 5B). On observe ainsi qu'une température de 1150 °C est nécessaire pour atteindre un facteur de puissance proche de la matrice sans siliciures. L'observation au microscope électronique en transmission (TEM) de ces matériaux valide qu'en dessous de 1150 °C, une forte proportion de particules métalliques n'a pas réagi avec la matrice pour former les siliciures désirés. L'inclusion du molybdène induit ici un effet de dopant : Les courbes de la figure 5 montrent que l'incorporation de Molybdène (Mo) dans une matrice $Si_{1-x}Ge_x$ induit une modification du coefficient Seebeck et de la conductivité électrique lorsque la température de frittage est inférieure ou égale à 1110 °C. Lorsque le

MoSi$_2$ est formé entièrement (à 1150 °C), le coefficient Seebeck et la conductivité électrique du matériau (Si$_{1-x}$Ge$_x$ + MoSi$_2$) sont similaires à ceux de la matrice sans inclusions.

La température minimum de frittage est donc comprise entre 1120 et 1150 °C.

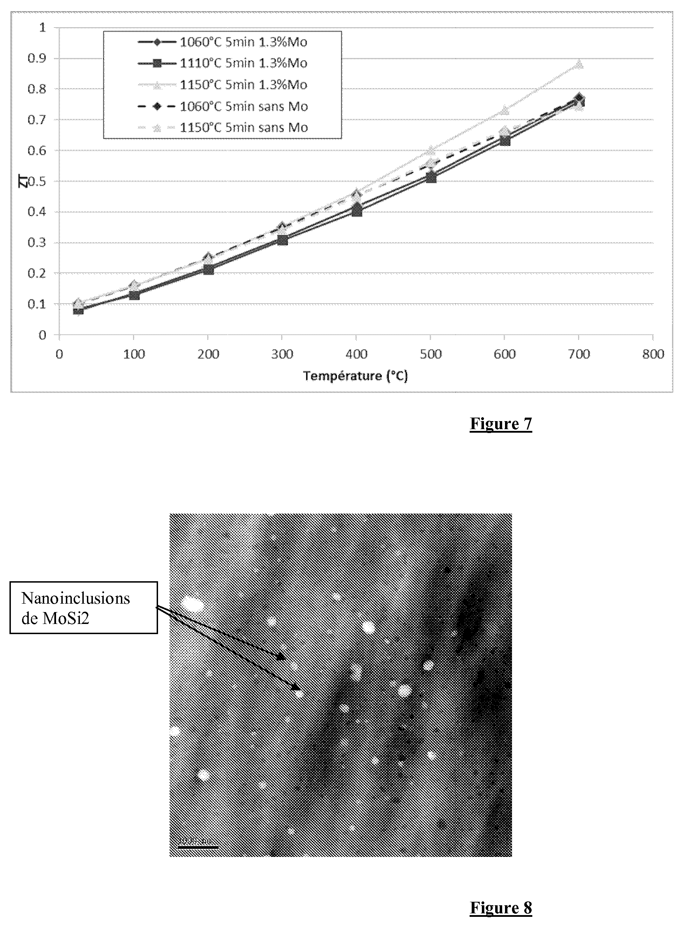

Le suivi de la conductivité thermique (figure 6) valide l'effet bénéfique de l'incorporation de molybdène nanométrique. A 1150 °C, on retrouve le facteur de puissance de la matrice et la conductivité thermique a bien été diminuée. Le facteur de mérite ZT s'en trouve donc amélioré de 16%, passant de 0,76 à 0,88 à 700 °C (figure 7).

Le document WO 2008/140596 décrit une plage de procédé large, différente et sortant de la plage de sélection décrite ici. En effet, il décrit une plage de température qui débute au point de fusion du matériau sans limitation haute. Dans le cas de la présente invention, la plage de température est inférieure à celle-ci ; elle est bornée et étroite.

L'observation par microscopie électronique en transmission (TEM) du matériau formé par le procédé selon l'invention est représentée aux figures 8 à 12. On retrouve ainsi l'ensemble des modifications microstructurales observées dans le cadre de l'invention :

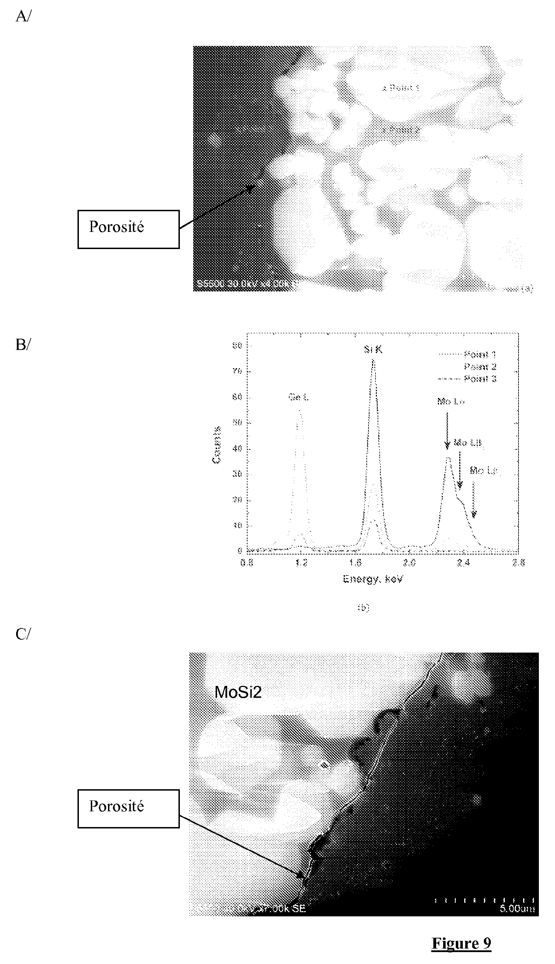

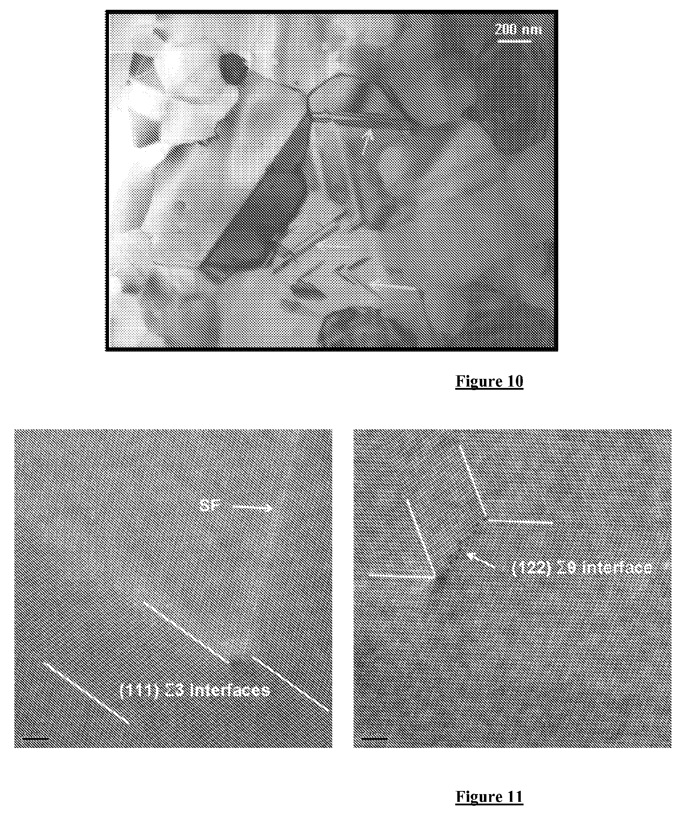

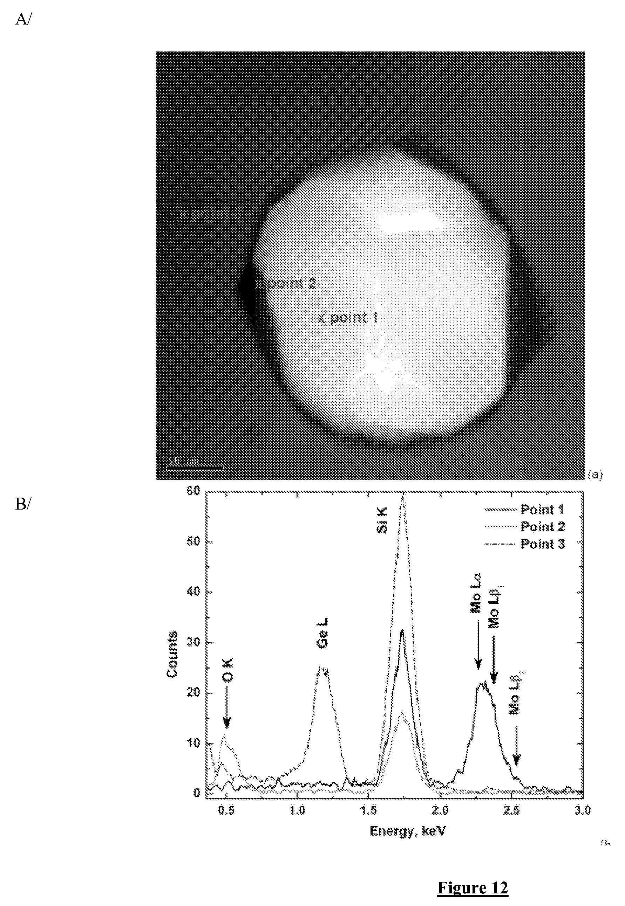

- formation des siliciures nanométriques (figure 8) ;
- modification de la composition sur le contour des inclusions (figures 9A et 9B) ;
- présence de porosité au niveau des inclusions (figures 9A et 9C) ;
- présence de mâcles (figure 10) et de joints spécifiques (figure 11) ;
- présence d'oxydes autour des inclusions (figure 12).

La validité du procédé selon l'invention a été vérifiée avec une autre stœchiométrie de l'alliage SiGe : Si$_{0.92}$Ge$_{0.08}$ (Si$_{1-x}$Ge$_x$ avec x = 0,08), dopé avec du phosphore, plus exactement : Si$_{0.913}$Ge$_{0.08}$P$_{0.007}$ pour le type n, et dopé avec du bore, plus exactement Si$_{0.913}$Ge$_{0.08}$B$_{0.007}$ pour le type p. Pour ces deux matériaux, 1,3% volumique de nanoparticules de molybdène ont été ajoutés par le même procédé que celui décrit précédemment. La taille moyenne des nanoparticules est de 20 nm.

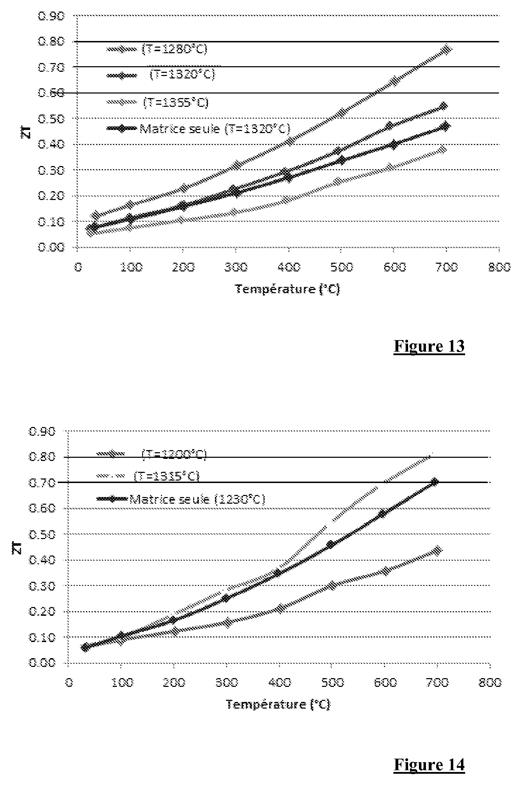

Dans ce cas également, une augmentation du ZT a été observée, ce facteur passant de 0,46 à 0,77 pour le type p (augmentation de 67 % ; Figure 13) et de 0,7 à 0,8 pour le type n (augmentation de 14 % ; Figure 14).

## RÉFÉRENCES

Wang, X. W., Lee, H., Lan, Y. C., Zhu, G. H., Joshi, G., Wang, D. Z., Yang, J., Muto, A. J., Tang, M. Y., Klatsky, J., Song, S., Dresselhaus, M. S., Chen, G.

and Ren, Z. F. 2008. Enhanced thermoelectric figure of merit in nanostructured n-type silicon germanium bulk alloy. Applied Physics Letters 93, 193121.

Mingo, N., Hauser, D., Kobayashi, N. P., Plissonnier, M. and Shakouri, A. 2009. Nanoparticle-in-alloy approach to efficient thermoelectrics: silicides in SiGe. NanoLetters, Vol. 9(2), 711-715.

Scoville, N., Bajgar, C., Rolfe, J., Fleurial, J.-P., Vandersande, J. 1995. Thermal conductivity reduction in SiGe alloys by the addition of nanophase particles. Nanostructured Materials, Vol.5(2), 207-223.

## Revendications

1. Procédé de fabrication d'un matériau thermoélectrique comprenant les étapes suivantes :

   - préparer une poudre à partir d'un alliage thermoélectrique au moins binaire (A$_x$B$_{1-x}$) destiné à servir de matrice ;
   - mélanger la poudre à des nanoparticules de métal pur (M) destinées à former des inclusions dans la matrice ;
   - soumettre le mélange à une étape de frittage à une température adaptée, comprise entre la température permettant d'atteindre 90% de la densification maximum et la température de fusion du métal M et de l'alliage (A$_x$B$_{1-x}$), au cours de laquelle des inclusions nanométriques de composition M$_a$A$_b$ et/ou M$_a$B$_b$ sont formées dans la matrice.

2. Procédé de fabrication d'un matériau thermoélectrique selon la revendication 1, *caractérisé en ce que* l'alliage est un alliage Si$_{1-x}$Ge$_x$, avantageusement avec 0,01<x≤0,2, encore plus avantageusement Si$_{0,8}$Ge$_{0,2}$.

3. Procédé de fabrication d'un matériau thermoélectrique selon la revendication 1 ou *2, caractérisé en ce que* l'alliage est dopé, avantageusement avec du bore pour une matrice SiGe dopée p (Si$_{1-x-y}$Ge$_x$B$_y$), ou avec du phosphore pour une matrice SiGe dopée n (Si$_{1-x-y}$Ge$_x$P$_y$), avec encore plus avantageusement 0,001≤y≤0,1.

4. Procédé de fabrication d'un matériau thermoélectrique selon la revendication 3, *caractérisé en ce que* l'agent dopant, avantageusement le bore ou le phosphore, représente de 10$^{19}$ à 10$^{21}$ particules par cm$^3$ de l'alliage.

5. Procédé de fabrication d'un matériau thermoélectrique selon l'une des revendications précédentes, *caractérisé en ce que* le métal est choisi dans le groupe suivant : le vanadium (Va), le tungstène (W), le molybdène (Mo), le zirconium (Zr), le titane (Ti), le chrome (Cr), le fer (Fe), le tantale (Ta), le cobalt (Co), l'osmium (Os), avantageusement dans le cas d'un alliage de type $Si_{1-x}Ge_x$.

6. Procédé de fabrication d'un matériau thermoélectrique selon l'une des revendications précédentes, *caractérisé* **en ce que** les nanoparticules de métal (M) représentent de 0,2 à 20 % en fraction volumique du mélange.

7. Procédé de fabrication d'un matériau thermoélectrique selon l'une des revendications précédentes, *caractérisé* **en ce que** l'étape de frittage se déroule dans une plage de température définie à partir d'un suivi de profil de densification, entre la température permettant de densifier le matériau à une vitesse maximale et la température de fusion du matériau.

8. Procédé de fabrication d'un matériau thermoélectrique selon la revendication 7, *caractérisé* **en ce que** pour une matrice en $Si_{0,8}Ge_{0,2}$ et des nanoparticules de Mo, l'étape de frittage se déroule à une température comprise entre 1150 et 1250 °C.

9. Procédé de fabrication d'un matériau thermoélectrique selon la revendication 7, *caractérisé* **en ce que** pour une matrice $Si_{0.92}Ge_{0.08}$ et des nanoparticules de Mo, l'étape de frittage se déroule à une température comprise entre 1280 et 1315 °C pour la matrice dopé au phosphore et entre 1280 °C et 1320 °C pour la matrice dopé au bore.

10. Procédé de fabrication d'un matériau thermoélectrique selon l'une des revendications précédentes, *caractérisé* **en ce que** le frittage est réalisé sous vide ou sous atmosphère inerte.

11. Procédé de fabrication d'un matériau thermoélectrique selon l'une des revendications précédentes, *caractérisé* **en ce que** le frittage est réalisé à l'aide de la technique SPS.

12. Procédé de fabrication d'un matériau thermoélectrique selon l'une des revendications précédentes, *caractérisé* **en ce que** le mélange est réalisé en présence d'un solvant organique inerte, tel que l'éthanol, et/ou d'agents dispersants.

**Patentansprüche**

1. Verfahren zur Herstellung eines thermoelektrischen Materials, das die folgenden wichtigsten Schritte umfasst:

- Herstellung eines Pulvers aus einem mindes-
tens binären, thermoelektrischen Legierung $(A_xB_{1-x})$, das als Matrix dienen soll.
- Vermischung des Pulvers mit reinen Metall-Nanoteilchen (M), die Einschlüsse in der Matrix bilden sollen;
- die Mischung einer Sinterungsetappe, bei geeigneter Temperatur aussetzen, die zwischen der <u>Temperatur liegt, mit der 90 % der maximalen Verdichtung erreicht werden können</u> und der Schmelztemperatur des Metalls M und der Legierung $(A_xB_{1-x})$, während der die nanometrischen Einschlüsse der Zusammensetzung $M_a$-$A_b$ und/oder $M_aB_b$ in der Matrix gebildet werden.

2. Verfahren zur Herstellung eines thermoelektrischen Materials gemäß Anspruch 1, *dadurch gekennzeichnet, dass* es sich bei der Legierung um eine $Si_{1-x}Ge_x$-Legierung handelt, vorteilhafterweise mit $0,01 < x \leq 0,2$, noch besser $Si_{0,8}Ge_{0,2}$.

3. Verfahren zur Herstellung eines thermoelektrischen Materials gemäß Anspruch 1 oder 2, *dadurch gekennzeichnet, dass* die Legierung dotiert ist, in vorteilhafter Weise mit Bor für eine p-dotierte SiGe-Matrix $(Si_{1-x-y}Ge_xB_y)$ oder mit Phosphor für eine n-dotierte SiGe-Matrix $(Si_{1-x-y}Ge_xP_y)$, oder noch besser $0,001 \leq y \leq 0,1$.

4. Verfahren zur Herstellung eines thermoelektrischen Materials gemäß Anspruch *3, dadurch gekennzeichnet, dass* das Dotierungsmittel, vorzugsweise Bor oder Phosphor, $10^{19}$ bis $10^{21}$ Teilchen pro $cm^2$ Legierung bildet.

5. Verfahren zur Herstellung eines thermoelektrischen Materials nach einem der vorhergehenden Ansprüche, *dadurch gekennzeichnet, dass* das Metall aus der folgenden Gruppe ausgewählt wird: Vanadium (Va), Wolfram (W), Molybdän (Mo), Zirkonium (Zr), Titan (Ti), Chrom (Cr), Eisen (Fe), Tantal (Ta), Kobalt (Co), Osmium (Os), vorteilhafter Weise im Falle einer Legierung vom Typ $Si_{1-x}Ge_x$.

6. Verfahren zur Herstellung eines thermoelektrischen Materials nach einem der vorhergehenden Ansprüche, **dadurch gekennzeichnet, dass** die Nanoteilchen aus reinem Metall (M) einen Volumenanteil von 0,2 bis 20 % darstellen.

7. Verfahren zur Herstellung eines thermoelektrischen Materials nach einem der vorhergehenden Ansprüche, *dadurch gekennzeichnet, dass* die Sinterungsetappe innerhalb einer Temperaturspanne stattfindet, die definiert wird auf Grundlage der Beobachtung eines Verdichtungsprofils, zwischen der Temperatur, bei der das Material mit maximaler Geschwindigkeit verdichtet werden kann und der Schmelztemperatur des Materials.

8. Verfahren zur Herstellung eines thermoelektrischen Materials nach Anspruch 7, *dadurch gekennzeichnet, dass* bei einer $Si_{0,8}Ge_{0,2}$-Matrix und Mo-Nanoteilchen die Sinterungsetappe bei einer Temperatur zwischen 1.150 und 1.250 °C stattfindet.

9. Verfahren zur Herstellung eines thermoelektrischen Materials nach Anspruch 7, *dadurch gekennzeichnet, dass* bei einer $Si_{0,92}Ge_{0,08}$-Matrix und Mo-Nanoteilchen die Sinterungsetappe bei einer Temperatur zwischen 1.280 und 1.315 °C für die Phosphor-dotierte Matrix und zwischen 1.280 °C und 1.320 °C für die Bor-dotierte Matrix stattfindet.

10. Verfahren zur Herstellung eines thermoelektrischen Materials nach einem der vorhergehenden Ansprüche, **dadurch gekennzeichnet, dass** die Sinterung im Vakuum oder unter inerter Atmosphäre ausgeführt wird.

11. Verfahren zur Herstellung eines thermoelektrischen Materials nach einem der vorhergehenden Ansprüche, *dadurch gekennzeichnet, dass* die Sinterung mit der SPS-Technik ausgeführt wird.

12. Verfahren zur Herstellung eines thermoelektrischen Materials nach einem der vorhergehenden Ansprüche, **dadurch gekennzeichnet, dass** die Mischung in Anwesenheit eines organischen, inerten Lösungsmittels ausgeführt wird, wie Ethanol und/ oder Dispergiermittel.

**Claims**

1. A thermoelectric material manufacturing method, comprising the steps of:

   - preparing a powder from an at least binary thermoelectric alloy ($A_xB_{1-x}$) intended to be used as a matrix;
   - mixing the powder with nanoparticles of pure metal (M) intended to form inclusions in the matrix;
   - submitting the mixture to a step of sintering at an adapted temperature, comprised between the temperature necessary to reach 90% of the maximum densification and the melting temperature of the metal (M) and of the alloy ($A_xB_{1-x}$), during which nanometric inclusions of composition $M_aA_b$ and/or $M_aB_b$ are formed in the matrix.

2. The thermoelectric material manufacturing method of claim 1, wherein the alloy is a $Si_{1-x}Ge_x$ alloy, advantageously with $0.01 < x \leq 0.2$, more advantageously still $Si_{0,8}Ge_{0,2}$-

3. The thermoelectric material manufacturing method 1 or 2, wherein the alloy is doped, advantageously with boron for a p-doped SiGe matrix ($Si_{1-x-y}Ge_xB_y$), or with phosphorus for an n-doped SiGe matrix ($Si_{1-x-y}Ge_xP_y$), with, more advantageously still, $0.001 \leq y \leq 0.1$.

4. The thermoelectric material manufacturing method of claim 3, wherein the dopant agent, advantageously boron or phosphorus, amounts to from $10^{19}$ to $10^{21}$ particles per $cm^3$ of the alloy.

5. The thermoelectric material manufacturing method of any of the foregoing claims, wherein the metal is selected from the following group: vanadium (Va), tungsten (W), molybdenum (Mo), zirconium (Zr), titanium (Ti), chromium (Cr), iron (Fe), tantalum (Ta), cobalt (Co), osmium (Os), advantageously in the case of an alloy of $Si_{1-x}Ge_x$ type.

6. The thermoelectric material manufacturing method of any of the foregoing claims, wherein the nanoparticles of metal (M) amount to a fraction by volume of the mixture in the range from 0.2 to 20%.

7. The thermoelectric material manufacturing method of any of the foregoing claims, wherein the sintering step takes place in a temperature range defined from a densification profile plot, between the temperature enabling to densify the material at a maximum speed and the melting temperature of the material.

8. The thermoelectric material manufacturing method of claim 7, wherein for a $Si_{0,8}Ge_{0,2}$ matrix and Mo nanoparticles, the sintering step occurs at a temperature in the range from 1,150 to 1,250 °C.

9. The thermoelectric material manufacturing method of claim 7, wherein for a $Si_{0,92}Ge_{0,08}$ matrix and Mo nanoparticles, the sintering step takes place at a temperature in the range from 1,280 to 1,315°C for the phosphorus-doped matrix and from 1,280°C to 1,320°C for the boron-doped matrix.

10. The thermoelectric material manufacturing method of any of the foregoing claims, wherein the sintering is performed in vacuum or in an inert atmosphere.

11. The thermoelectric material manufacturing method of any of the foregoing claims, wherein the sintering is performed by means of the SPS technique.

12. The thermoelectric material manufacturing method of any of the foregoing claims, wherein the mixing is performed in the presence of an inert organic solvent, such as ethanol, and/or other dispersing agents.

Matrice Si$_{1-x}$Ge$_x$

Nanoparticules métalliques
(M= W, Mo Cr,Ti,Zr,Os,Ta)

Matrice Si$_{1-x}$Ge$_x$

Nanoparticules métalliques à base de
siliciure M$_a$Si$_b$

Siliciuration
par diffusion
du silicium
de la matrice
dans
l'inclusion
métallique

Figure 1

**Cas 1**

Changement de composition de la matrice SiGe autour des inclusions : Appauvrissement en Si autour de l'inclusion due à sa siliciuration.

Si$_{1-x}$Ge$_x$ matrix

Si1-x-$\underline{\delta x}$Ge1-x+$\underline{\delta x}$

**Cas 2**

Création de porosité autour des inclusions : facteur supplémentaire d'abaissement de la conductivité thermique sans altérer le transport électronique

Si$_{1-x}$Ge$_x$ matrix

Si1-x-$\underline{\delta x}$Ge1-x+$\underline{\delta x}$

Porosité dans la zone appauvrie en Silicium

**Cas 3**

Présence d'oxyde autour des inclusions : facteur supplémentaire d'abaissement de la conductivité thermique sans altérer le transport électronique

Si$_{1-x}$Ge$_x$ matrix

Si1-x-$\underline{\delta x}$Ge1-x+$\underline{\delta x}$

$SiO_2$ autour des siliciures

**Figure 2**

**Figure 3**

**Figure 4**

A/

B/

**Figure 5**

**Figure 6**

Figure 7

Nanoinclusions de MoSi2

Figure 8

A/

Porosité

B/

C/

MoSi2

Porosité

**Figure 9**

**Figure 10**

**Figure 11**

A/

B/

**Figure 12**

**Figure 13**

**Figure 14**

**EP 2 855 056 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2008140596 A

**Littérature non-brevet citée dans la description**

- **WANG, X. W. ; LEE, H. ; LAN, Y. C. ; ZHU, G. H. ; JOSHI, G. ; WANG, D. Z. ; YANG, J. ; MUTO, A. J. ; TANG, M. Y. ; KLATSKY, J.** Enhanced thermoelectric figure of merit in nanostructured n-type silicon germanium bulk alloy. *Applied Physics Letters,* 2008, vol. 93, 193121

- **MINGO, N. ; HAUSER, D. ; KOBAYASHI, N. P. ; PLISSONNIER, M. ; SHAKOURI, A.** Nanoparticle-in-alloy approach to efficient thermoelectrics: silicides in SiGe. *NanoLetters,* 2009, vol. 9 (2), 711-715
- **SCOVILLE, N. ; BAJGAR, C. ; ROLFE, J. ; FLEURIAL, J.-P. ; VANDERSANDE, J.** Thermal conductivity reduction in SiGe alloys by the addition of nanophase particles. *Nanostructured Materials,* 1995, vol. 5 (2), 207-223